# EUROPEAN PATENT APPLICATION

(11) **EP 4 746 155 A2**
(43) Date of publication of application: **20.05.2026**
(21) Application number: 25215889.4
(22) Date of filing: 14.11.2025
(51) Int. Cl.: H01M 50/244, H01M 50/256, H01M 50/264, H01M 50/289

(54) **PORTABLE ENERGY STORAGE APPARATUS AND ENERGY STORAGE SYSTEM**

(30) Priority: 15.11.2024 CN 202411639589
(71) Applicant: Shenzhen Hithium Hero Energy Equity Technology Co., Ltd, Shenzhen, Guangdong 518110 (CN); Xiamen Hithium Energy Storage Technology Co., Ltd., Xiamen, Fujian 361100 (CN)
(72) Inventor: DAI, Wei, Shenzhen, 518110 (CN)
(74) Representative: Mewburn Ellis LLP

(57) **Abstract**

A portable energy storage apparatus (100) and an energy storage system (1000) are provided. The portable energy storage apparatus (100) includes a housing assembly (10), an energy storage module (20), a connecting base (30), and a connecting member (40). The housing assembly (10) includes a bottom housing (11) and a top housing (12). The bottom housing (11) is provided with a connecting protrusion (111) protruding from an inner sidewall surface of the bottom housing (11). The connecting protrusion (111) defines an accommodating cavity (1111) therein and an opening (1112) in communication with the accommodating cavity (1111). The energy storage module (20) includes an energy storage unit (21) and a fixing member (22) wrapped around an outer periphery of the energy storage unit (21). The energy storage unit (21) is fixed inside the bottom housing (11) through the fixing member (22). The fixing member (22) is provided with a fixing portion (221) that defines a first through hole (222) extending therethrough in a first preset direction (f1). The connecting base (30) is embedded in the accommodating cavity (1111) through the opening (1112).

## Description

### TECHNICAL FIELD

This disclosure relates to the field of energy storage technology, and in particular, to a portable energy storage apparatus and an energy storage system.

### BACKGROUND

In recent years, energy storage products are applied more and more widely, and the demand for portable energy storage apparatuses is increasing. The portable energy storage apparatus gains favor of more and more users due to its advantages of small size, light weight, convenience of movement, and similar benefits.

In the related art, the portable energy storage apparatus generally includes components such as a bottom housing, a top cover, and a battery. The battery is fixed inside the bottom housing by a fixing member. In order to improve the connection reliability between the fixing member and the bottom housing, a screw post having an insert nut embedded therein is generally provided inside the bottom housing, and a through hole is defined on the fixing member, so that a screw passes through the through hole and is threaded with the insert nut to fasten the fixing member, thereby enabling the battery to be securely fixed inside the bottom housing. When the screw post is prepared, the insert nut is generally fixed at an appropriate position in an injection mold in advance, and then plastic is injected for molding. In this way, after the mold is opened, the insert nut is tightly wrapped and embedded in the cooled and solidified plastic, so that the screw post with the insert nut embedded therein can be obtained.

However, in the related art, the screw post is prone to shrinkage, and at the same time, since the insert nut and the surrounding plastic member (i.e., the screw post) have different coefficients of thermal expansion, the residual internal stress on the plastic member is excessively large after injection molding, so that the plastic member is prone to cracking, thereby further resulting in unstable connection of components and posing potential safety hazards.

### SUMMARY

A portable energy storage apparatus and an energy storage system are disclosed in embodiments of the present disclosure, which can establish a connection between an energy storage module and a bottom housing by means of screw connection, so as to improve the convenience of assembly and disassembly of an energy storage unit while reducing the risk of cracking and shrinkage of the connecting protrusion, thereby improving the connection stability of the energy storage module in the bottom housing.

In order to achieve the described object, in a first aspect, the present disclosure discloses a portable energy storage apparatus. The portable energy storage apparatus includes a housing assembly, an energy storage module, a connecting base, and a connecting member. The housing assembly includes a bottom housing and a top housing that are arranged in a first preset direction and are separable. In the first preset direction, a height of the bottom housing is larger than a height of the top housing, and the bottom housing is provided with a connecting protrusion protruding from an inner sidewall surface of the bottom housing. The connecting protrusion defines an accommodating cavity therein and an opening in communication with the accommodating cavity. The energy storage module is disposed inside the bottom housing. The energy storage module includes an energy storage unit and a fixing member wrapped around an outer periphery of the energy storage unit. The energy storage unit is fixed inside the bottom housing through the fixing member. The fixing member is provided with a fixing portion. The fixing portion defines a first through hole extending therethrough in the first preset direction. A structural strength of the connecting base is different from a structural strength of the connecting protrusion. The connecting base is embedded in the accommodating cavity through the opening. The connecting member passes through the first through hole from up to down in the first preset direction and is connected to the connecting base.

In the portable energy storage apparatus provided in the present disclosure, the connecting protrusion is provided on the inner sidewall of the bottom housing, the connecting protrusion defines the accommodating cavity and the opening in communication with the accommodating cavity, so that the connecting base can be embedded and fixed in the accommodating cavity through the opening. In this way, it is possible to avoid embedding and fixing the connecting base inside the connecting protrusion by means of insert injection molding, thereby reducing the occurrence of shrinkage, and avoiding excessive residual internal stress on the connecting protrusion that may cause cracking, so as to reduce the risk of cracking of the connecting protrusion. Thus, the connection reliability between the energy storage module and the bottom housing can be ensured, the connection stability of the energy storage module inside the bottom housing can be improved, and potential safety hazards can be reduced.

As an optional implementation, in an embodiment of the first aspect of the present disclosure, the structural strength of the connecting base is greater than the structural strength of the connecting protrusion.

In the present disclosure, since the connecting base can still be embedded and fixed inside the connecting protrusion, and the structural strength of the connecting base is greater than the structural strength of the connecting protrusion, it is still possible to ensure that the structure (i.e., the connecting base, the connecting protrusion, etc.) connected to the connecting member on the bottom housing has relatively strong structural strength, thereby ensuring the connection reliability between the energy storage module and the bottom housing.

As an optional implementation mode, in an embodiment of the first aspect of the present disclosure, the connecting member includes a locking member. The locking member passes through the first through hole from up to down in the first preset direction and is screwed into the connecting base. In this way, the energy storage module can be fastened and connected to the bottom housing by means of threads, thereby simplifying the assembly and disassembly manners of the energy storage module and the bottom housing, and enabling the connection manner between the energy storage module and the bottom housing to be stable and reliable.

As an optional implementation, in an embodiment of the first aspect of the present disclosure, the opening is defined on a surface of the connecting protrusion positioned facing towards the energy storage module. The connecting protrusion defines a second through hole on a top wall of the connecting protrusion in the first preset direction. The second through hole is in communication with the accommodating cavity and the first through hole. The connecting member passes through the first through hole and the second through hole in sequence from up to down in the first preset direction and is connected to the connecting base.

Compared with the opening being defined on the top surface of the connecting protrusion positioned facing towards the top housing, the opening is defined on the surface of the connecting protrusion positioned facing towards the energy storage module, which is equivalent to the connecting protrusion having the top wall in the first preset direction, and having no sidewall in a direction facing towards the energy storage module. In this way, on the one hand, due to the existence of the top wall of the connecting protrusion, the overall size of the connecting protrusion and the connecting base in the first preset direction can be greater, thereby enhancing the load-bearing capacity of the connecting protrusion and the connecting base as a whole in the first preset direction. Since the fixing portion is located at the top of the connecting protrusion in the first preset direction, the energy storage module applies a force to the connecting protrusion and the connecting base mainly in the first preset direction. Hence, defining the opening on the surface of the connecting protrusion positioned facing towards the energy storage module, enables the connecting protrusion and the connecting base as a whole to support the energy storage module more reliably and stably. On the other hand, since the connecting protrusion does not have a sidewall in the direction facing towards the energy storage module, it is convenient to leave a space for accommodating the energy storage module, thereby realizing a miniaturized design of the portable energy storage apparatus.

As an optional implementation, in an embodiment of the first aspect of the present disclosure, a direction perpendicular to both the first preset direction and an opening direction of the opening is defined as a second preset direction. The opening direction is defined as a direction from the connecting protrusion towards the energy storage module. The connecting protrusion has a first sidewall and a second sidewall that are opposite to each other in the second preset direction. The connecting protrusion is provided with a limiting rib protruding from the first sidewall, the second sidewall, or the first and second sidewalls, and the limiting rib is located in the accommodating cavity. The limiting rib abuts against the connecting base. For example, the limiting rib is used for limiting the movement travel of the connecting base in the second preset direction, so as to prevent the connecting base from rotating relative to the connecting protrusion. Thus, each of the wall thickness of the first sidewall and the wall thickness of the second sidewall can be kept substantially the same as the wall thickness of the bottom housing, so as to avoid shrinkage, while ensuring the position of the connecting base to be fixed, without lateral displacement in the second preset direction.

As an optional implementation, in an embodiment of the first aspect of the present disclosure, a gap is defined between the connecting base and the limiting rib in the second preset direction, and/or an adhesive layer bonded to both the connecting base and the limiting rib is provided in the gap between the connecting base and the limiting rib in the second preset direction.

In the above design, there is the gap defined between the connecting base and the limiting rib in the second preset direction, that is, the space in the accommodating cavity for accommodating the connecting base is larger than the volume of the connecting base, so that the accommodating cavity can be used for fitting connecting bases of different sizes, allowing assembly of connecting bases with various apertures, providing high flexibility. At the same time, the gap between the connecting base and the limiting rib is filled with an adhesive to form the adhesive layer. Therefore, not only can the adhesive layer be used to fill the gap between the connecting base and the limiting rib, so that the limiting rib can indirectly abut against the connecting base via the adhesive layer to achieve the limiting effect on the connecting base, but also the adhesive layer can be used to tightly fix the connecting base in the accommodation cavity, so as to prevent the connecting base from disengaging from the accommodation cavity of the connecting protrusion through the opening.

As an optional implementation, in an embodiment of the first aspect of the present disclosure, the connecting protrusion is provided with a first support rib protruding from a bottom wall of the connecting protrusion in the first preset direction. The first support rib is located in the accommodating cavity. The first support rib abuts against the connecting base. In addition, combined with the design in which the opening is defined on the surface of the connecting portion positioned facing towards the energy storage module, it can be ensured that the connecting base cannot be vertically assembled into the accommodating cavity, thereby preventing vertical displacement of the connecting base in the first preset direction, so as to fix the position of the connecting base. At the same time, the thickness of the bottom wall of the connecting protrusion in the first preset direction can also be prevented from being too thick, so that the wall thickness of the bottom wall of the connecting protrusion can be kept substantially equal to the wall thickness of the bottom housing, thereby avoiding the occurrence of shrinkage.

As an optional implementation, in an embodiment of the first aspect of the present disclosure, the connecting protrusion is provided with a boss extending in the first preset direction and protruding from the top wall of the connecting protrusion in the first preset direction. The boss is located outside the accommodating cavity. The boss is spaced apart from the inner sidewall surface of the bottom housing. The second through holes extend through the boss in the first preset direction.

By providing the boss which is spaced apart from the inner sidewall of the bottom housing, and allowing the second through hole to extend through the boss in the first preset direction, the local thickening design of the top wall of the connecting protrusion is realized. Specifically, the thickness of the top wall of the connecting protrusion at the peripheral position where the connection member passes through is increased, and the wall thickness of the top wall of the connecting protrusion at the position where the top wall of the connecting protrusion is connected to the inner sidewall surface of the bottom housing can be kept substantially equal, so as to avoid shrinkage at the connection position between the top wall of the connecting protrusion and the inner sidewall surface of the bottom housing. Therefore, the boss can increase the supporting capability of the connecting protrusion for the energy storage module, while reducing the possibility of shrinkage, thereby ensuring the structural stability of the connecting protrusion.

As an optional implementation, in an embodiment of the first aspect of the present disclosure, the boss is provided with multiple first reinforcing ribs arranged at intervals in a circumferential direction of the boss. Each of the multiple first reinforcing ribs is connected to both an outer peripheral surface of the boss and the top wall of the connecting protrusion in the first preset direction. In this way, the structural strength of the boss can be reinforced by using the first reinforcing rib, so that the boss can bear a relatively large force, thereby further improving the supporting capability of the connecting protrusion for the energy storage module, and improving the connection reliability between the energy storage module and the bottom housing.

As an optional implementation, in an embodiment of the first aspect of the present disclosure, the connecting protrusion is provided with at least one second reinforcing rib on the top wall of the connecting protrusion in the first preset direction. The at least one second reinforcing rib is located outside the accommodating cavity. The at least one second reinforcing rib is connected to the inner sidewall surface of the bottom housing. The top wall of the connecting protrusion is connected to the inner sidewall surface of the bottom housing through the at least one second reinforcing rib, so as to distribute stress, thereby reducing the possibility of shrinkage and avoiding the shrinkage caused by a local increase in the wall thickness of the top wall of the connecting protrusion.

As an optional implementation, in an embodiment of the first aspect of the present disclosure, the connecting protrusion is provided with a second support rib on the bottom wall of the connecting protrusion in the first preset direction. The second support rib is located outside the accommodating cavity. The second support rib is connected to the inner sidewall surface of the bottom housing. The second support rib extends in the first preset direction to be connected to an inner bottom surface of the bottom housing. In this way, the second support rib can be used to support the connecting protrusion, so as to prevent the connecting protrusion from being suspended in the first preset direction, thereby further improving the supporting capability of the connecting protrusion for the energy storage module, and improving the connection reliability between the energy storage module and the bottom housing.

As an optional implementation, in an embodiment of the first aspect of the present disclosure, a direction perpendicular to both the first preset direction and an opening direction of the opening is defined as a second preset direction. The second support rib includes at least two support sub-ribs arranged at intervals in the second preset direction. Multiple connecting ribs arranged at intervals in the first preset direction are connected between adjacent two of the at least two support sub-ribs.

Compared with supporting the connecting protrusion by using a single second support rib with a relatively thick thickness, using the at least two support sub-ribs spaced apart from each other can ensure the support function of the second support rib for the connecting protrusion, while avoiding excessive thickness of the second support rib in the second preset direction, so that the thickness of the second support rib can be substantially equal to the wall thickness of the bottom housing, thereby avoiding the occurrence of shrinkage. At the same time, in the present disclosure, the connecting rib is further provided between two adjacent support sub-ribs, and two ends of the connecting rib are respectively connected to the two adjacent support sub-ribs, thereby improving the overall structural stability of the second support rib, further improving the supporting capability of the connecting protrusion for the energy storage module, and improving the connection reliability between the energy storage module and the bottom housing.

As an optional implementation mode, in an embodiment of the first aspect of the present disclosure, the bottom housing has a first abutting surface at one end of the bottom housing closer to the top housing. The first abutting surface abuts against the top housing. The top housing has a second abutting surface at one end of the top housing closer to the bottom housing. The second abutting surface abuts against the first abutting surface. A positioning protrusion is provided on one of the first abutting surface and the second abutting surface, and a positioning groove is defined in the other of the first abutting surface and the second abutting surface. The positioning protrusion is embedded in the positioning groove. In this way, when the top housing is assembled to the bottom housing, the engagement of the positioning protrusion with the positioning groove can provide positioning and limiting for assembly of the top housing and the bottom housing, thereby facilitating the assembly of the top housing and the bottom housing, and improving the assembly efficiency of the top housing and the bottom housing.

As an optional implementation, in an embodiment of the first aspect of the present disclosure, when the positioning protrusion is provided on the first abutting surface and the positioning groove is defined in the second abutting surface, the positioning groove extends through an inner sidewall surface of the top housing, the top housing is provided with multiple reinforcing ribs on the inner sidewall surface of the top housing, the multiple reinforcing ribs are arranged at intervals in a circumferential direction of the top housing, and each of the multiple reinforcing ribs extends in the first preset direction to abut against the positioning protrusion.

In this way, the reinforcing ribs can be used to enhance the structural strength of the top housing and ensure the service life of the top housing. The reinforcing ribs can also be used as a groove wall of the positioning groove to abut against the positioning protrusion, so that a positioning groove with a relatively large size in a direction of the wall thickness of the top housing can be defined, and the positioning groove with the relatively large size can be engaged with the positioning protrusion. In addition, the wall thickness of the top housing is reduced, thereby facilitating the realization of the lightweight design of the top housing, so that the user can carry the portable energy storage apparatus by hand conveniently.

As an optional implementation, in an embodiment of the first aspect of the present disclosure, the portable energy storage apparatus further includes a circuit board assembly. The circuit board assembly is disposed inside the bottom housing. The circuit board assembly is located at one side of the energy storage module. Each of a part of the multiple reinforcing ribs disposed closer to the circuit board assembly defines an avoidance notch for avoiding the circuit board assembly. Therefore, the interference of the reinforcing ribs with the circuit board assembly inside the bottom housing can be prevented, and the smooth assembly of various components can be ensured, thereby ensuring the integrity of the internal structure of the bottom housing.

In a second aspect, the present disclosure discloses an energy storage system. The energy storage system has the portable energy storage apparatus in the first aspect. The energy storage system including the portable energy storage apparatus in the first aspect can likewise implement the connection between the energy storage module and the bottom housing by means of screw connection. Therefore, the convenience of disassembly and assembly of the energy storage unit can be improved, and the risk of cracking and shrinkage of the connecting protrusion can be reduced, thereby improving the connection stability of the energy storage module in the bottom housing.

Compared with the related art, in the portable energy storage apparatus provided in the present disclosure, the connecting protrusion is provided on the inner sidewall of the bottom housing, the connecting protrusion defines the accommodating cavity and the opening in communication with the accommodating cavity, so that the connecting base can be embedded and fixed in the accommodating cavity through the opening. In this way, it is possible to avoid embedding and fixing the connecting base inside the connecting protrusion by means of insert injection molding, thereby reducing the occurrence of shrinkage, and avoiding excessive residual internal stress on the connecting protrusion that may cause cracking, so as to reduce the risk of cracking of the connecting protrusion. Thus, the connection reliability between the energy storage module and the bottom housing can be ensured, the connection stability of the energy storage module inside the bottom housing can be improved, and potential safety hazards can be reduced.

### BRIEF DESCRIPTION OF THE DRAWINGS

In order to describe technical solutions of embodiments more clearly, the following will give a brief description of accompanying drawings used for describing the embodiments. Apparently, the accompanying drawings described below merely illustrate some embodiments. Those of ordinary skill in the art can also obtain other accompanying drawings based on the accompanying drawings described below without creative efforts.
FIG. 1 is a schematic structural view of a portable energy storage apparatus disclosed in an embodiment of the present disclosure.
FIG. 2 is an exploded schematic structural view of a portable energy storage apparatus disclosed in an embodiment of the present disclosure.
FIG. 3 is an exploded structural schematic view of an energy storage module and a circuit board assembly disclosed in an embodiment of the present disclosure.
FIG. 4 is a schematic structural view of a bottom housing and a connecting base disclosed in an embodiment of the present disclosure.
FIG. 5 is a partial enlarged view of FIG. 4 at Circle M.
FIG. 6 is an exploded schematic structural view of a bottom housing and a connecting base disclosed in an embodiment of the present disclosure.
FIG. 7 is a partial enlarged view of FIG. 6 at Circle N.
FIG. 8 is a top view of a portable energy storage apparatus disclosed in an embodiment of the present disclosure.
FIG. 9 is a cross-sectional view of the portable energy storage apparatus disclosed in an embodiment of the present disclosure, taken along direction A-A in FIG. 8.
FIG. 10 is a partial enlarged view of FIG. 9 at Box O.
FIG. 11 is a schematic structural view of a top housing disclosed in an embodiment of the present disclosure.
FIG. 12 is a block view of an energy storage system disclosed in an embodiment of the present disclosure.

Key reference signs in the accompanying drawings are described as follows: 1000 - energy storage system; 100 - portable energy storage apparatus; 10 - housing assembly; 11 - bottom housing; 11a - first abutting surface; 111 - connecting protrusion; 111a - first sidewall; 111b - second sidewall; 1111 - accommodating cavity; 1112 - opening; 1113 - second through hole; 112 - limiting rib; 113 - first support rib; 114 - boss; 115a - first reinforcing rib; 115b - second reinforcing rib; 116 - adhesive reduction groove; 117 - second support rib; 117a - sub support rib; 118 - connecting rib; 119 - positioning protrusion; 12 - top housing; 12a - second abutting surface; 121 - positioning groove; 122 - reinforcing rib; 1221 - avoidance notch; 20 - energy storage module; 21 - energy storage unit; 22 - fixing member; 22a - first fixing component; 22b - second fixing component; 22c - connecting component; 221 - fixing portion; 222 - first through hole; 30 - connecting base; 40 - connecting member; 50 - circuit board assembly; f1 - first preset direction; f2 - opening direction; f3 - second preset direction.

### DETAILED DESCRIPTION

In order to make the purposes, technical solutions, and advantages of the present disclosure clearer, the following will describe the present disclosure in detail with a combination of accompanying drawings and embodiments. It should be understood that, specific embodiments described herein are merely for explaining, rather than limiting, the present disclosure.

Unless otherwise defined, all technical and scientific terms used herein have the same meaning as commonly understood by one of ordinary skill in the technical field to which the present disclosure belongs. The terms used herein are only for describing the purpose of embodiments of the present disclosure, and are not intended to limit the present disclosure.

It can be understood that terms "first", "second", and the like used in the present disclosure are used to describe various elements, but these elements are not limited by these terms. The terms are only used to distinguish a first element from another element. For example, without departing from the scope of the present disclosure, a first through hole may be referred to as a second through hole, and similarly, the second through hole may be referred to as the first through hole. Both the first through hole and the second through hole are through holes, but they are not the same through hole.

It can be understood that, in the following embodiments, if there are electric signals or data transmission among connected circuits, modules, and units, "connection" should be understood as "electrical connection", "communication connection", and the like.

As used herein, unless otherwise clearly stated in the context, singular forms "a", "an", and "the" can also include plural forms. It should also be noted that, the term "include/contain" or "have" is used to clearly indicate existence of the feature, integer, step, operation, assembly, component, or groups thereof, but does not exclude existence or addition of one or more other features, integers, steps, operations, assemblies, components, or groups thereof. Meanwhile, the term "and/or" used in this specification is merely an association relationship describing associated objects, indicating that there may be three relationships, for example, A and/or B may indicate three cases: A alone, A and B, and B alone. That is, the term "and/or" used in this specification includes any and all combinations of the items listed in the related art.

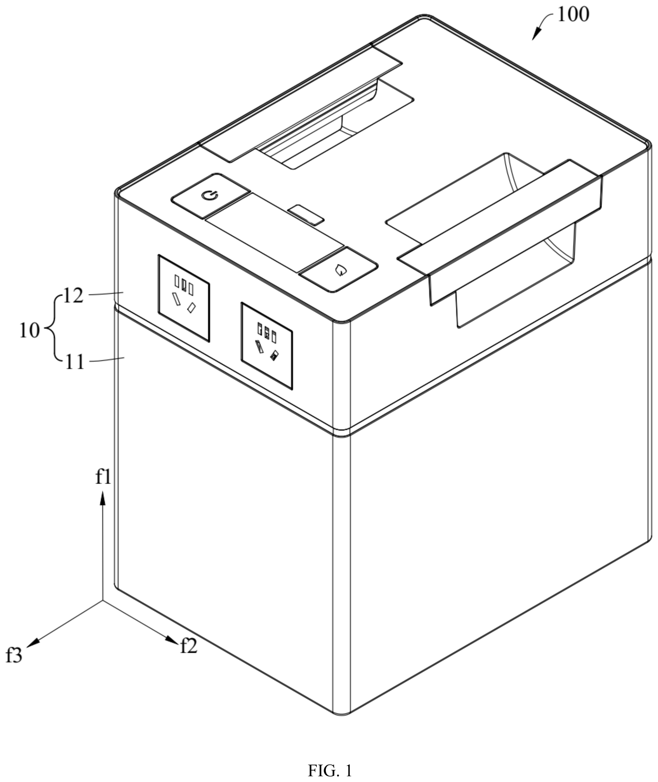

Referring to FIG. 1, an embodiment of the present disclosure discloses an energy storage apparatus, for example, a portable energy storage apparatus 100, and in particular, disclose a portable energy storage apparatus 100 with a miniaturized design, so that a user can carry the portable energy storage apparatus 100 by hand, so as to facilitate moving the position of the portable energy storage apparatus 100.

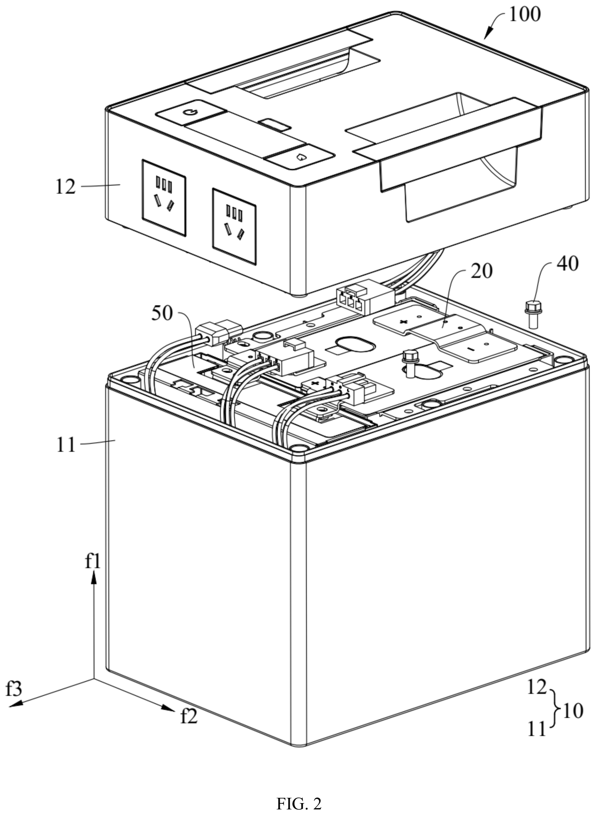

Referring to FIG. 1 and FIG. 2, the portable energy storage apparatus 100 provided in an embodiment of the present disclosure includes a housing assembly 10 and an energy storage module 20.

In the present disclosure, the housing assembly 10 includes a bottom housing 11 and a top housing 12 that are arranged in a first preset direction f1 and are separable. In the first preset direction f1, the height of the bottom housing 11 is larger than the height of the top housing 12. The energy storage module 20 is disposed inside the bottom housing 11. The energy storage module 20 includes an energy storage unit 21 and a fixing member 22 wrapped around the outer periphery of the energy storage unit 21. Therefore, the energy storage unit 21 can be fixed inside the bottom housing 11 by means of the fixing member 22, thereby avoiding the following situations. The energy storage unit 21 shakes inside the bottom housing 11 to cause the connecting terminal to become detached, thereby resulting in a failure of electrical connection between the energy storage unit 21 and a control assembly.

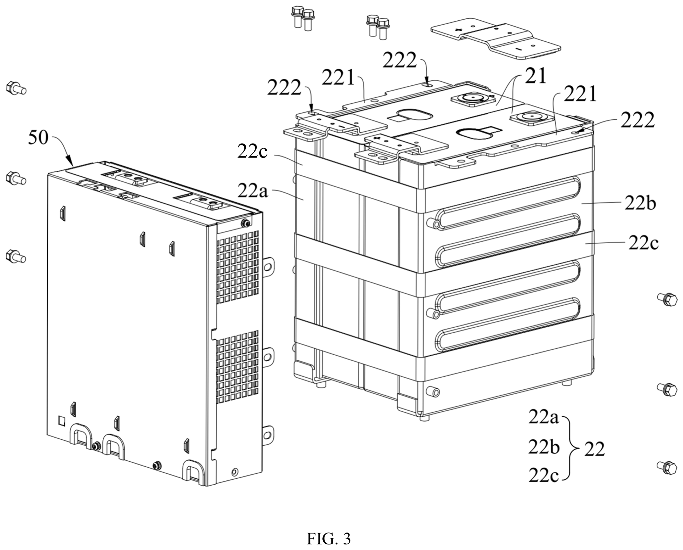

Optionally, the energy storage unit 21 may include one or more cells. When the energy storage unit 21 includes multiple cells, such as two, three, four, five, six, or more cells, the multiple cells may be arranged linearly in a first direction, or may be arranged in an array in the first direction and a second direction, where the first direction, the second direction, and the first preset direction f1 are perpendicular to one another pairwise. In addition, the multiple cells may be connected to each other in series or in parallel. Exemplarily, as illustrated in FIG. 2 and FIG. 3, the bottom housing 11 has a cuboid structure, where the first preset direction f1 may be understood as a height direction of the bottom housing 11, the first direction may be understood as a width direction of the top housing 12, and the second direction may be understood as a length direction of the bottom housing 11. Furthermore, the energy storage unit 21 includes two cells connected in series, each of the two cells has a cuboid structure, and the two cells connected in series are arranged in the first direction.

As an embodiment, as illustrated in FIG. 2 and FIG. 3, the fixing member 22 may include a first fixing component 22a, a second fixing component 22b, and a connecting component 22c. The large surface sides of the cells at the both ends in a cell arrangement direction abut against the inner sidewall of the first fixing component 22a and the inner sidewall of the second fixing component 22b, respectively. The connecting component 22c is fastened around the outer sidewall of the first fixing component 22a and the outer sidewall of the second fixing component 22b, so as to clamp and fix the multiple cells. That is, the first fixing component 22a covers the large surface side of the cell at one end, the second fixing component 22b covers the large surface side of the cell at the other end, and the outer sidewall of the first fixing component 22a and the outer sidewall of the second fixing component 22b are sleeved with the connecting component 22c to clamp and fix the multiple cells, so that the multiple cells may be fixed inside the bottom chassis 11 by means of the fixing member 22. The connecting component 22c may be a flexible member, such as a binding band, a strap, or the like.

In this way, during actual assembly, the first fixing component 22a may be made to cover the large surface side of the cell at one end and the second fixing component 22b may be made to cover the large surface side of the cell at the other end first, and then the connecting component 22c is fastened around the outer sidewall of the first fixing component 22a and the outer sidewall of the second fixing component 22b, so as to clamp and fix the multiple cells. Compared with the fixing member 22 having an integrated structure with an inner cavity and a mounting opening, the fixing member 22 in the present disclosure can avoid the following situations. When the energy storage unit 21 is mounted into the inner cavity from the mounting opening along the cavity wall of the inner cavity, the cavity wall of the inner cavity may rub against the energy storage unit 21, thereby resulting in wear of the energy storage unit 21.

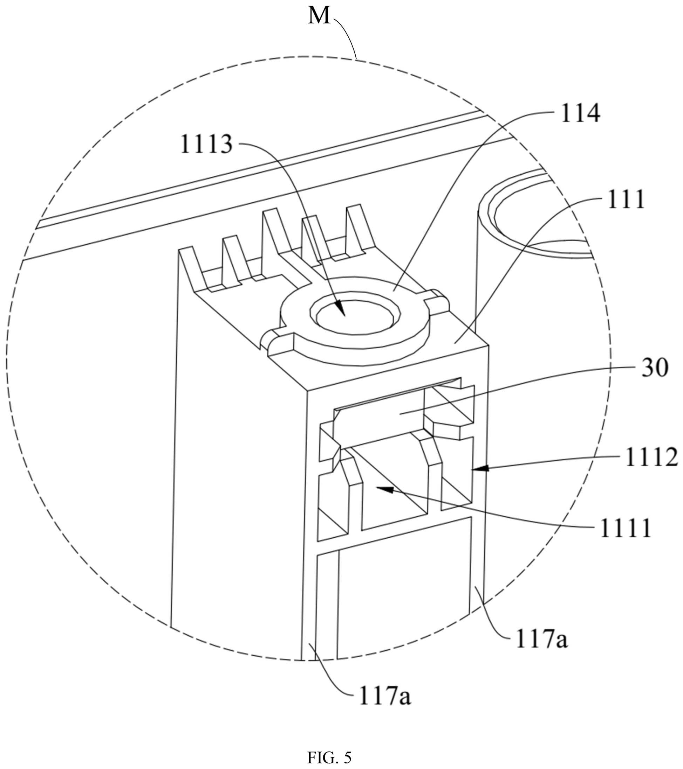

Referring to FIG. 2 to FIG. 5, in the present disclosure, the bottom housing 11 is provided with a connecting protrusion 111 protruding from an inner sidewall surface of the bottom housing 11. The connecting protrusion 111 defines an accommodating cavity 1111 therein and an opening 1112 in communication with the accommodating cavity 1111. The fixing member 22 is provided with a fixing portion 221. The fixing portion 221 is located at the top of the connecting protrusion 111 in the first preset direction f1. The fixing portion 221 defines a first through hole 222 extending therethrough in the first preset direction f1. In addition, the portable energy storage apparatus 100 provided in the embodiment of the present disclosure further includes a connecting base 30 and a connecting member 40. The structural strength of the connecting base 30 is different from the structural strength of the connecting protrusion 111. The connecting base 30 is embedded in the accommodating cavity 1111 of the connecting protrusion 111 through the opening 1112 of the connecting protrusion 111. The connecting member 40 passes through the first through hole 222 from up to down in the first preset direction f1 and is connected to the connecting base 30.

Optionally, the bottom housing 11 and the connecting protrusion 111 may be integrally formed, and the material of the bottom housing 11 may be the same as the material of the connecting protrusion 111. Exemplarily, each of the material of both the bottom housing 11 and the material of the connecting protrusion 111 is silica gel, plastic, rubber, or the like. The material of the connecting base 30 may be metal, such as stainless steel, copper, copper alloy, aluminum, aluminum alloy, as well as silica gel, plastic, rubber, and the like with a hardness greater than the hardness of the connecting protrusion 111.

By means of the described design solution, it is possible to avoid embedding and fixing the connecting base 30 inside the connecting protrusion 111 by means of insert injection moulding, thereby reducing the occurrence of shrinkage, and avoiding excessive residual internal stress on the connecting protrusion 111 that may cause cracking, so as to reduce the risk of cracking of the connecting protrusion 111. Thus, the connection reliability between the energy storage module 20 and the bottom housing 11 can be ensured, the connection stability of the energy storage module 20 inside the bottom housing 11 can be improved, and potential safety hazards can be reduced.

In some embodiments, the structural strength of the connecting base 30 is greater than the structural strength of the connection bump 111.

In the present disclosure, since the connecting base 30 can still be embedded and fixed inside the connecting protrusion 111, and the structural strength of the connecting base 30 is greater than the structural strength of the connecting protrusion 111, it is still possible ensure that the structure (i.e., the connecting base 30, the connecting protrusion 111, etc.) connected to the connecting member 40 on the bottom housing 11 has relatively strong structural strength, thereby ensuring the connection reliability between the energy storage module 20 and the bottom housing 11.

In some embodiments, the connecting member 40 includes a locking member. The locking member passes through the first through hole 222 from up to down in the first preset direction f1 and is screwed into the connecting base 30. In this way, the energy storage module 20 can be fastened and connected to the bottom housing 11 by means of threads, thereby simplifying the assembly and disassembly manners of the energy storage module 20 and the bottom housing 11, and enabling the connection manners of the energy storage module 20 and the bottom housing 11 to be stable and reliable. The connecting member 40 in this embodiment may be a bolt, a screw, or the like.

In other embodiments, the connecting member 40 may include a snap-fit member. The snap-fit member passes through the first through hole 222 from up to down in the first preset direction f1 and is connected to the connecting base 30 in a snap-fit manner.

Optionally, the shape of the connecting base 30 may be a square, for example, a rectangle, a square, or the like, and the shape of the accommodating cavity 1111 may be a square adapted to the shape of the connecting base 30. Specifically, when the shape of the connecting base 30 is a rectangle, the shape of the accommodating cavity 1111 is also a rectangle. When the shape of the connecting base 30 is a square, the shape of the accommodating cavity 1111 is also a square. In this way, when the connecting member 40 is tightened or loosened, rotation of the connecting base 30 can be prevented, so as to ensure that the connecting member 40 can be smoothly connected to or detached from the connecting base 30, thereby smoothly implementing the assembly and disassembly of the energy storage module 20.

In addition, for a screw post internally embedded with an insert nut, the exterior of the insert nut generally has knurling or other patterns to prevent the insert nut from rotating and loosening. However, the depth at which the knurling or other patterns are embedded in the screw post is limited, and there is still a relatively high probability that the insert nut may rotate or loosen, or even cut the screw post to cause cracks in the screw post, thereby affecting the stability of the structure. In the present disclosure, the connecting base 30 and the accommodating cavity 1111, both having square shapes, are used to replace the design of knurling or other patterns on the exterior of the insert nut, so that the connecting base 30 can be effectively prevented from rotating or loosening in the accommodating cavity 1111, and the probability of cracks occurring in the connecting protrusion 111 can thus be reduced. Therefore, the structural strength of the integral structure of the connecting protrusion 111 and the connecting base 30 is ensured, thereby facilitating the improvement of the connection reliability between the energy storage module 20 and the bottom housing 11.

Further, the shape of the connecting protrusion 111 also corresponds to a square, so as to facilitate a square accommodating cavity 1111 to be defined in the connecting protrusion 111, and facilitate keeping wall thicknesses at respective positions of the connecting protrusion 111 equal, thereby avoiding the connecting protrusion 111 from shrinkage.

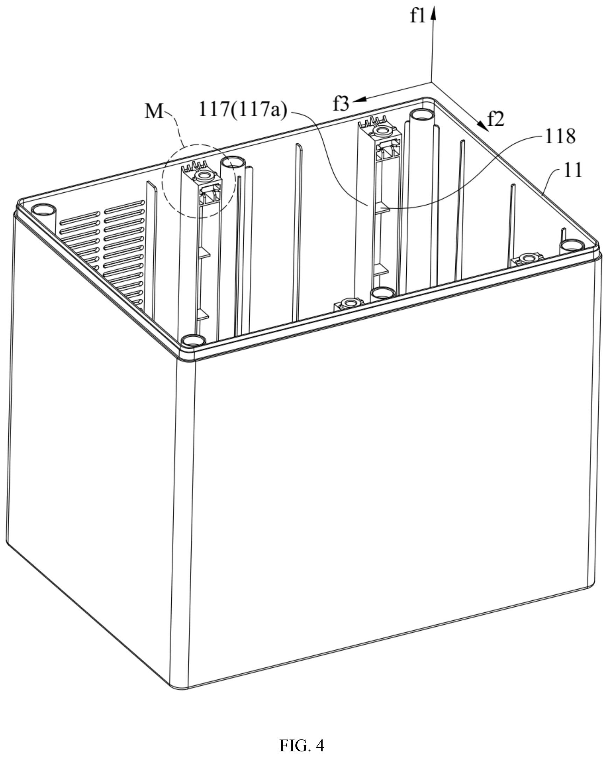

It can be understood that the connecting protrusion 111 may be provided on at least one inner sidewall surface of the bottom housing 11 in a width direction of the bottom housing 11, or may be provided on at least one inner sidewall surface of the bottom housing 11 in a length direction of the bottom housing 11, and one or more connecting protrusions 111 may be provided on an inner sidewall surface of the bottom housing 11. The present disclosure does not specifically limit the positions and the number of the connecting projections 111, that is, the specific positions and the number of the connecting projections 111 can be selected and determined according to actual requirements. Exemplarily, as illustrated in FIG. 4, the bottom housing 11 is provided with two connecting projections 111 protruding from each of both inner sidewall surfaces of the bottom housing 11 in the width direction of the bottom housing 11.

As an embodiment, the opening 1112 may be defined on a surface of the connecting protrusion 111 positioned facing towards the energy storage module 20. The connecting protrusion 111 defines a second through hole 1113 on a top wall of the connecting protrusion 111 in the first preset direction f1, and the second through hole 1113 is in communication with the accommodating cavity 1111 and the first through hole 222. The connecting member 40 passes through the first through hole 222 and the second through hole in sequence from up to down in the first preset direction f1 and is screwed into the connecting base 30.

Compared with the opening 1112 being defined on the top surface of the connecting protrusion 111 positioned facing towards the top housing 12, the opening 1112 is defined on the surface of the connecting protrusion 111 positioned facing towards the energy storage module 20, which is equivalent to the connecting protrusion 111 having the top wall in the first preset direction f1, and having no sidewall in a direction facing towards the energy storage module 20. In this way, on the one hand, due to the existence of the top wall of the connecting protrusion 111, the overall size of the connecting protrusion 111 and the connecting base 30 in the first preset direction f1 can be greater, thereby enhancing the load-bearing capacity of the connecting protrusion 111 and the connecting base 30 as a whole in the first preset direction f1. Since the fixing portion 221 is located at the top of the connecting protrusion 111 in the first preset direction f1, the energy storage module 20 applies a force to the connecting protrusion 111 and the connecting base 30 mainly in the first preset direction f1. Hence, defining the opening 1112 on the surface of the connecting protrusion 111 positioned facing towards the energy storage module 20, enables the connecting protrusion 111 and the connecting base 30 as a whole to support the energy storage module 20 more reliably and stably. On the other hand, since the connecting protrusion 111 does not have a sidewall in the direction facing towards the energy storage module 20, it is convenient to leave a space for accommodating the energy storage module 20, thereby realizing a miniaturized design of the portable energy storage apparatus 100.

In the present disclosure, for ease of description, a direction perpendicular to both the first preset direction f1 and the opening direction f2 of the opening 1112 is defined as a second preset direction f3. The opening direction f2 is defined as a direction from the connecting protrusion 111 towards the energy storage module. It should be understood that the foregoing definitions are merely limitations for the convenience of description, and should not be used to limit the protection scope of the present disclosure.

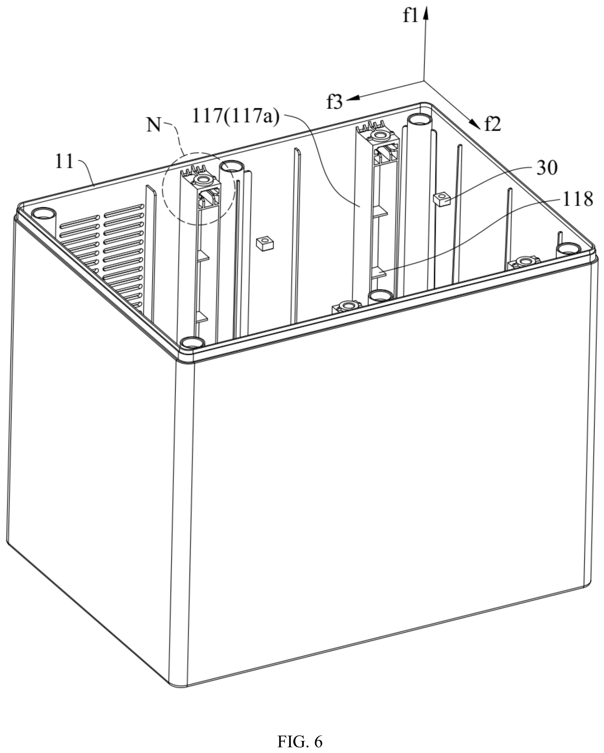

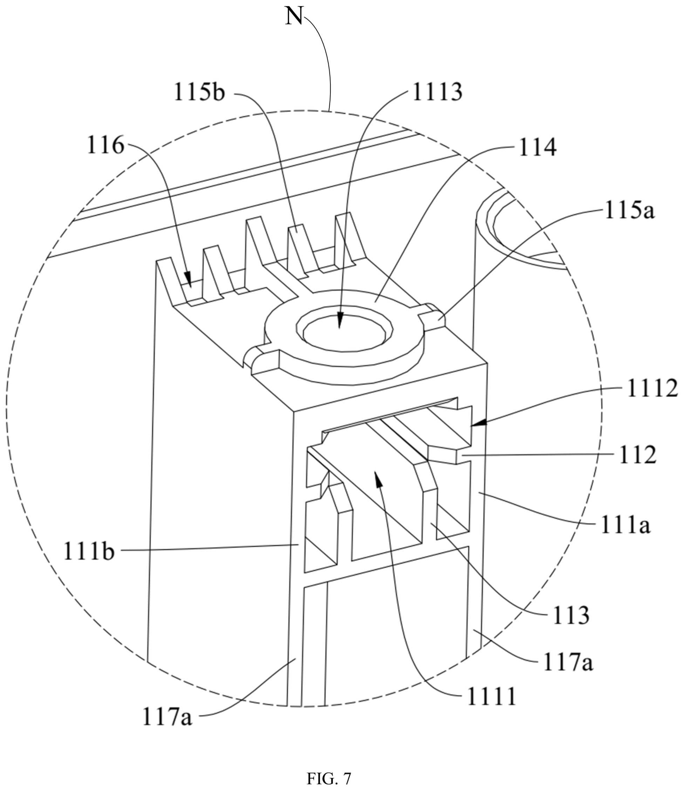

As an embodiment, as illustrated in FIG. 6 and FIG. 7, the connecting protrusion 111 in the present disclosure has a first sidewall 111a and a second sidewall 111b that are opposite to each other in the second preset direction f3. The connecting protrusion 111 is provided with a limiting rib 112 protruding from the first sidewall 111a, the second sidewall 111b, or the first sidewall 111a and the second sidewall 112b, and the limiting rib 112 is located in the accommodating cavity 1111. That is, the limiting rib 112 located in the accommodating cavity 1111 may only protrude from the first sidewall 111a, may only protrude from the second sidewall 111b, or may protrude from each of the first sidewall 111a and the second sidewall 111b. The limiting rib 112 abuts against the connecting base 30. For example, the limiting rib 112 is used for limiting the movement travel of the connecting base 30 in the second preset direction f3. That is, the connecting base 30 will not move in the second preset direction f3 under the limiting effect of the limiting rib 112. Thus, each of the wall thickness of the first sidewall 111a and the wall thickness of the second sidewall 111b can be kept substantially the same as the wall thickness of the bottom housing 11, so as to avoid shrinkage, while ensuring the position of the connecting base 30 to be fixed, without lateral displacement in the second preset direction f3.

Optionally, a gap is defined between the connecting base 30 and the limiting rib 112 in the second preset direction f3, and/or an adhesive layer (not shown) bonded to both the connecting base 30 and the limiting rib 112 is provided in the gap between the connecting base 30 and the limiting rib 112 in the second preset direction f3, so that the limiting rib 112 indirectly abuts against the connecting base 30 via the adhesive layer.

In the above design, there is the gap defined between the connecting base 30 and the limiting rib 112 in the second preset direction f3, that is, the space in the accommodating cavity 1111 for accommodating the connecting base 30 is larger than the volume of the connecting base 30, so that the accommodating cavity 1111 can be used for fitting connecting bases 30 of different sizes, allowing assembly of connecting bases 30 with various apertures, providing high flexibility. At the same time, the gap between the connecting base 30 and the limiting rib 112 is filled with an adhesive to form the adhesive layer. Therefore, not only can the adhesive layer be used to fill the gap between the connecting base 30 and the limiting rib 112, so that the limiting rib 112 can indirectly abut against the connecting base 30 via the adhesive layer to achieve the limiting effect on the connecting base 30, but also the adhesive layer can be used to tightly fix the connecting base 30 in the accommodation cavity 1111, so as to prevent the connecting base 30 from disengaging from the accommodation cavity 1111 of the connecting protrusion 111 through the opening 1112.

Optionally, there is a distance between an upper surface of the limiting rib 112 in the first preset direction f1 and the top wall of the connecting protrusion 111, and there is a distance between a lower surface of the limiting rib 112 in the first preset direction f1 and a bottom wall of the connecting protrusion 111. Therefore, the thickness of the limiting rib 112 in the first preset direction f1 can be prevented from being too thick, so that the wall thicknesses of the limiting rib 112, the connecting protrusion 111, the bottom housing 11, etc., can be kept substantially equal, thereby reducing the possibility of shrinkage. Meanwhile, the distance between the upper surface of the limiting rib 112 and the top wall of the connecting protrusion 111 and the distance between the lower surface of the limiting rib 112 and the bottom wall of the connecting protrusion 111 may serve as an adhesive filling space, thereby increasing the bonding area between the connecting base 30 and the adhesive layer, and improving the stability of the connecting base 30 in the accommodating cavity 1111.

As an embodiment, as illustrated in FIG. 6 and FIG. 7, the connecting protrusion 111 is provided with a first support rib 113 protruding from the bottom wall of the connecting protrusion 111 in the first preset direction f1, and the first support rib 113 is located in the containing cavity 1111. The first support rib 113 abuts against the connecting base 30. In addition, combined with the design in which the opening 1112 is defined on the surface of the connecting portion 111 positioned facing towards the energy storage module, it can be ensured that the connecting base 30 cannot be vertically assembled into the accommodating cavity 1111, thereby preventing vertical displacement of the connecting base 30 in the first preset direction f1, so as to fix the position of the connecting base 30. At the same time, the thickness of the bottom wall of the connecting protrusion 111 in the first preset direction f1 can also be prevented from being too thick, so that the wall thickness of the bottom wall of the connecting protrusion 111 can be kept substantially equal to the wall thickness of the bottom housing 11, thereby avoiding the occurrence of shrinkage.

Optionally, there is a distance between one of both sidewall surfaces of the first support rib 113 in the second preset direction f3 and the first sidewall 111a, and there is a distance between the other of both sidewall surfaces of the first support rib 113 in the second preset direction f3 and the second sidewall 111b. In this way, the thickness of the first support rib 113 in the second preset direction f3 can be prevented from being too thick, so that the wall thickness of the first support rib 113, the wall thickness of the limiting rib 112, the wall thickness of the connecting projection 111, and the wall thickness of the bottom housing 11 can be kept substantially equal, thereby reducing the possibility of shrinkage.

Further, there may be multiple, such as, two, three, four, etc., first support ribs 113. The multiple first support ribs 113 are arranged at intervals in the second preset direction f3. In this way, on the one hand, the thickness of the first support ribs 113 in the second preset direction f3 can be prevented from being too thick, so that the wall thickness of the first support ribs 113, the wall thickness of the limiting rib 112, the wall thickness of the connecting protrusion 111, and the wall thickness of the bottom housing 11, can be kept substantially equal, thereby reducing the possibility of shrinkage. On the other hand, the distance defined between two adjacent first support ribs 113 can serve as an adhesive filling space, thereby increasing the bonding area between the connecting base 30 and the adhesive layer, and improving the stability of the connecting base 30 in the accommodating cavity 1111.

As an embodiment, the connecting protrusion 111 is provided with a boss 114 extending in the first preset direction f1 and protruding from the top wall of the connecting protrusion 111 in the first preset direction f1. The boss 114 is located outside the accommodating cavity 1111. The boss 114 is spaced apart from the inner sidewall surface of the bottom housing 11. The second through hole 1113 extends through the boss 114 in the first preset direction f1. By providing the boss 114 which is spaced apart from the inner sidewall of the bottom housing 11, and allowing the second through hole 1113 to extend through the boss 114 in the first preset direction f1, the local thickening design of the top wall of the connecting protrusion 111 is realized. Specifically, the thickness of the top wall of the connecting protrusion at the peripheral position where the connection member passes through is increased, and the wall thickness of the top wall of the connecting protrusion 111 at the position where the top wall of the connecting protrusion 111 is connected to the inner sidewall surface of the bottom housing 11 can be kept substantially equal, so as to avoid shrinkage at the connection position between the top wall of the connecting protrusion 111 and the inner sidewall surface of the bottom housing 11. Therefore, the boss 114 can increase the supporting capability of the connecting protrusion 111 for the energy storage module, while reducing the possibility of shrinkage, thereby ensuring the structural stability of the connecting protrusion 111.

Optionally, the boss 114 is provided with multiple first reinforcing ribs 115a arranged at intervals in a circumferential direction of the boss 114. Each of the multiple first reinforcing ribs 115a is connected to both an outer peripheral surface of the boss 114 and the top wall of the connecting protrusion 111 in the first preset direction f1. In this way, the structural strength of the boss 114 can be reinforced by using the first reinforcing rib 115a, so that the boss 114 can bear a relatively large force, thereby further improving the supporting capability of the connecting protrusion 111 for the energy storage module, and improving the connection reliability between the energy storage module and the bottom housing 11.

As an embodiment, the connecting protrusion 111 is provided with at least one second reinforcing rib 115b on the top wall of the connecting protrusion 111 in the first preset direction f1, and the at least one second reinforcing rib 115b is located outside the accommodating cavity 1111. The at least one second reinforcing rib 115b is connected to the inner sidewall surface of the bottom housing 11. The top wall of the connecting protrusion 111 is connected to the inner sidewall surface of the bottom housing 11 through the at least one second reinforcing rib 115b, so as to distribute stress, thereby reducing the possibility of shrinkage and avoiding the shrinkage caused by a local increase in the wall thickness of the top wall of the connecting protrusion 111.

Optionally, there may be multiple, such as two, three, four, five, six, etc., second reinforcing ribs 115b. The multiple second reinforcing ribs 115b are arranged at intervals in the second preset direction f3, so that stress can be better dispersed and the possibility of shrinkage is thus reduced. In addition, the thickness of the second reinforcing ribs 115b in the second preset direction f3 is prevented from being too thick, thereby also preventing occurrence of shrinkage in the second reinforcing ribs 115b.

As an embodiment, an adhesive reduction groove 116 is defined at a connection between the top wall of the connecting protrusion 111 in the first preset direction f1 and the inner sidewall surface of the bottom housing 11. By designing the adhesive reduction groove 116 at the connection between of the top wall of the connecting protrusion 111 and the inner sidewall surface of the bottom housing 11, an adhesive reduction treatment is carried out, thereby eliminating the sink-mark problem on the front surface of the bottom housing 11 at the connection between the bottom housing 11 and the connecting protrusion 111.

As an embodiment, as illustrated in FIG. 6 and FIG. 7, the connecting protrusion 111 is provided with a second support 117 on the bottom wall of the connecting protrusion 111 in the first preset direction f1, and the second support rib 117 is located outside the accommodating cavity 1111. The second support rib 117 is connected to the inner sidewall surface of the bottom housing 11. The second support rib 117 extends in the first preset direction f1 to be connected to an inner bottom surface of the bottom housing 11. In this way, the second support rib 117 can be used to support the connecting protrusion 111, so as to prevent the connecting protrusion 111 from being suspended in the first preset direction f1, thereby further improving the supporting capability of the connecting protrusion 111 for the energy storage module, and improving the connection reliability between the energy storage module and the bottom housing 11.

Optionally, the second support rib 117 includes at least two support sub-ribs 117a arranged at intervals in the second preset direction f3. Multiple connecting ribs 118 arranged at intervals in the first preset direction f1 are connected between adjacent two of the at least two support sub-ribs 117a. Compared with supporting the connecting protrusion 111 by using a single second support rib 117 with a relatively thick thickness, using the at least two support sub-ribs 117a spaced apart from each other can ensure the support function of the second support rib 117 for the connecting protrusion 111, while avoiding excessive thickness of the second support rib in the second preset direction f3, so that the thickness of the second support rib 117 can be substantially equal to the wall thickness of the bottom housing 11, thereby avoiding the occurrence of shrinkage. At the same time, in the present disclosure, the connecting rib 118 is further provided between two adjacent support sub-ribs 117a, and two ends of the connecting rib 118 are respectively connected to the two adjacent support sub-ribs 117a, thereby improving the overall structural stability of the second support rib 117, further improving the supporting capability of the connecting protrusion 111 for the energy storage module, and improving the connection reliability between the energy storage module 20 and the bottom housing 11.

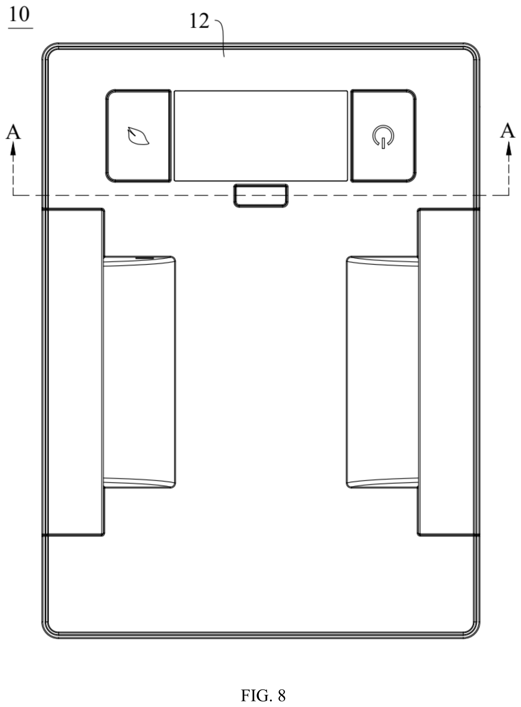

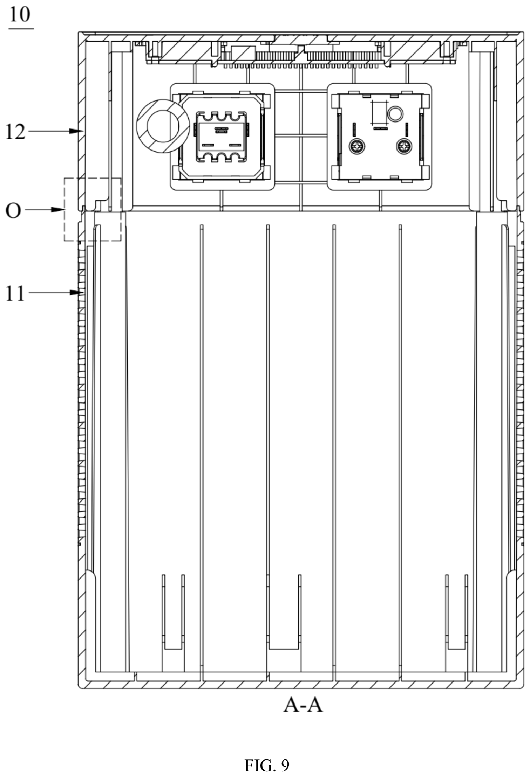

As an embodiment, referring to FIG. 8 to FIG. 10 in combination, the bottom housing 11 has a first abutting surface 11a at one end of the bottom housing 11 closer to the top housing 12, and the first abutting surface 11a abuts against the top housing 12. The top housing 12 has a second abutting surface 12a at one end of the top housing 12 closer to the bottom housing 11, and the second abutting surface 12a abuts against the first abutting surface 11a. A positioning protrusion 119 is provided on one of the first abutting surface 11a and the second abutting surface 12a, and a positioning groove 121 is defined in the other of the first abutting surface 11a and the second abutting surface 12a. That is, when the positioning protrusion 119 is provided on the first abutting surface 11a, the positioning groove 121 is defined in the second abutting surface 12a, and when the positioning groove 121 is defined in the first abutting surface 11a, the positioning protrusion 119 is provided on the second abutting surface 12a. The positioning protrusion 119 is embedded in the positioning groove 121. In this way, when the top housing 12 is assembled to the bottom housing 11, the engagement of the positioning protrusion 119 with the positioning groove 121 can provide positioning and limiting for assembly of the top housing 12 and the bottom housing 11, thereby facilitating the assembly of the top housing 12 and the bottom housing 11, and improving the assembly efficiency of the top housing 12 and the bottom housing 11.

When the positioning protrusion 119 is provided on the first abutting surface 11a and the positioning groove 121 is defined in the second abutting surface 12a, the positioning groove 121 extends through an inner sidewall surface of the top housing 12, the top housing 12 is provided multiple reinforcing ribs 122 on the inner sidewall surface of the top housing 12, the multiple reinforcing ribs 122 are arranged at intervals in the circumferential direction of the top housing 12, and each of the multiple reinforcing ribs 122 extends in the first preset direction f1 to abut against the positioning protrusion 119, for example, to abut against the positioning protrusion 19 at one side of the positioning protrusion 119 in the wall thickness direction of the bottom housing 11. In this way, the reinforcing ribs 122 can be used to enhance the structural strength of the top housing 12 and ensure the service life of the top housing 12. The reinforcing ribs 122 can also be used as a groove wall of the positioning groove 121 to abut against the positioning protrusion 119, so that a positioning groove 121 with a relatively large size in a direction of the wall thickness of the top housing 12 can be defined, and the positioning groove 121 with the relatively large size can be engaged with the positioning protrusion 119. In addition, the wall thickness of the top housing 12 is reduced, thereby facilitating the realization of the lightweight design of the top housing 12, so that the user can carry the portable energy storage apparatus 100 by hand conveniently.

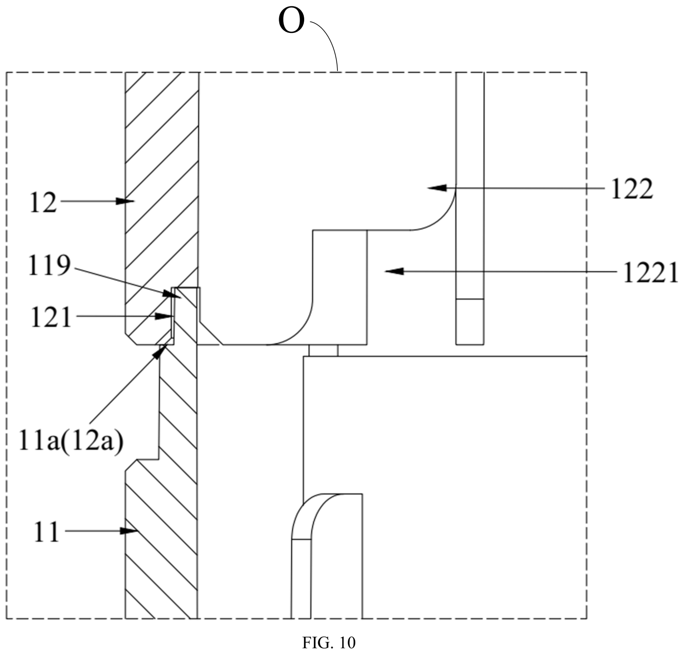

As an embodiment, as illustrated in FIG. 10, FIG. 11, and FIG. 2, the portable energy storage apparatus 100 further includes a circuit board assembly 50. The circuit board assembly 50 is disposed inside the bottom housing 11. The circuit board assembly 50 is located at one side of the energy storage module 20. Each of a part of the multiple reinforcing ribs 122 disposed closer to the circuit board assembly 50 defines an avoidance notch 1221 for avoiding the circuit board assembly 50. Therefore, the interference of the reinforcing ribs 122 with the circuit board assembly 50 inside the bottom housing 11 can be prevented, and the smooth assembly of various components can be ensured, thereby ensuring the integrity of the internal structure of the bottom housing 11.

The circuit board assembly 50 may be integrated with electronic components such as a bidirectional buck-boost converter and an inverter. Therefore, when the energy storage module 20 of the present disclosure is discharging, a low-voltage direct current (DC) (e.g., a 3.2V DC) output by the energy storage module 20 is first boosted to a 310V DC by using the bidirectional buck-boost converter on the circuit board assembly 50, and then inverted into a 220V alternating current (AC) by using the inverter on the circuit board assembly 50, so as to meet the charging requirements of the device to be charged, thereby implementing the discharge of the energy storage module 20. When the energy storage module 20 of the present disclosure is being charged, an externally input 220V AC is first inverted into a 310V DC by using the inverter on the circuit board assembly 50, and then stepped down to a 3.2V DC by using the bidirectional buck-boost converter on the circuit board assembly 50, so as to meet the charging requirements of the energy storage module 20, thereby implementing the charging of the energy storage module 20.

It can be understood that, in actual use, the circuit board assembly 50 may, according to application scenarios of the portable energy storage apparatus 100, be integrated with different functional electronic components on the circuit board assembly 50 to meet application requirements.

Further, on the circuit board assembly 50 of the present disclosure, in addition to being integrated with the bidirectional buck-boost converter and the inverter, a battery management system (BMS for short) may also be integrated, so that the circuit board assembly 50 can serve as a key component for monitoring, controlling, and protecting the energy storage module 20. For example, the circuit board assembly 50 can monitor and manage parameters such as a voltage, a temperature, a charging state, and a discharging state of the energy storage module 20, thereby preventing dangerous situations such as over-charging, over-discharging, over-current, and short-circuiting, ensuring safe operation of the energy storage module 20 and prolonging the service life of the energy storage module 20.

Optionally, the circuit board assembly 50 is disposed on a side where a small surface of each cell is located. Since expansion and deformation of the cell mainly occur on a large surface of the cell, a degree of extrusion of the circuit board assembly 50 during expansion of the cell can be reduced, so as to avoid damage to the circuit board assembly 50, thereby helping to improve the service life of the circuit board assembly 50.

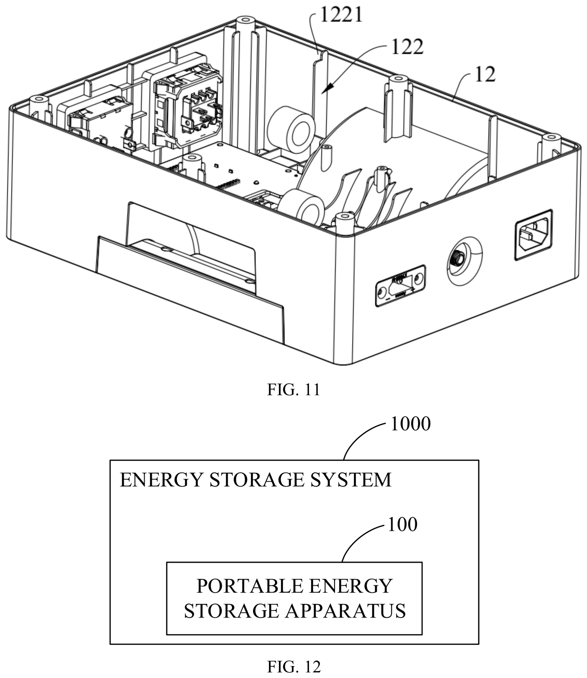

Referring to FIG. 12, an embodiment of the present disclosure further discloses an energy storage system 1000. The energy storage system 1000 has the portable energy storage apparatus 100 according to any one of the foregoing embodiments. Specifically, the energy storage system 1000 may include a power supply apparatus and the portable energy storage apparatus according to any one of the foregoing embodiments, and the portable energy storage apparatus can be used to supply power to a power-consuming apparatus. It can be understood that the energy storage system having the portable energy storage apparatus described above can bring about the same or similar beneficial effects as the portable energy storage apparatus. For details, reference may be made to the description of the embodiments of the portable energy storage apparatus, which are not repeated herein.

The technical features in the above embodiments can be combined in any manner. In an effort to provide a concise description, not all of the possible combinations of the technical features in the above embodiments are described. However, any combination of these technical features should be considered within the scope as recited in this specification unless there is a contradiction in such a combination.

Furthermore, the above embodiments only show several implementations of the present disclosure, and the descriptions thereof are relatively specific and detailed, but cannot be understood as a limitation to the scope of the present disclosure. It should be noted that for those of ordinary skill in the art, without departing from the concept of the present disclosure, several modifications and improvements can be made, and these all belong to the protection scope of the present disclosure. Therefore, the contents of this specification shall not be construed as a limitation to the present disclosure, and the protection scope of the present disclosure shall be referred to the appended claims.

## Claims

1. A portable energy storage apparatus (100), comprising:
a housing assembly (10), wherein the housing assembly (10) comprises a bottom housing (11) and a top housing (12) that are arranged in a first preset direction (f1) and are separable; in the first preset direction (f1), a height of the bottom housing (11) is larger than a height of the top housing (12), and the bottom housing (11) is provided with a connecting protrusion (111) protruding from an inner sidewall surface of the bottom housing (11); and the connecting protrusion (111) defines an accommodating cavity (1111) therein and an opening (1112) in communication with the accommodating cavity (1111);
an energy storage module (20), wherein the energy storage module (20) is disposed inside the bottom housing (11), the energy storage module (20) comprises an energy storage unit (21) and a fixing member (22) wrapped around an outer periphery of the energy storage unit (21), the energy storage unit (21) is fixed inside the bottom housing (11) through the fixing member (22), the fixing member (22) is provided with a fixing portion (221), and the fixing portion (221) defines a first through hole (222) extending therethrough in the first preset direction (f1);
a connecting base (30), wherein a structural strength of the connecting base (30) is different from a structural strength of the connecting protrusion (111), and the connecting base (30) is embedded in the accommodating cavity (1111) through the opening (1112); and
a connecting member (40), wherein the connecting member (40) passes through the first through hole (222) from up to down in the first preset direction (f1) and is connected to the connecting base (30).

2. The portable energy storage apparatus (100) of claim 1, wherein the structural strength of the connecting base (30) is greater than the structural strength of the connecting protrusion (111).

3. The portable energy storage apparatus (100) of claim 1, wherein the connecting member (40) comprises a locking member, and the locking member passes through the first through hole (222) from up to down in the first preset direction (f1) and is screwed into the connecting base (30).

4. The portable energy storage apparatus (100) of claim 1, wherein the opening (1112) is defined on a surface of the connecting protrusion (111) positioned facing towards the energy storage module (20), the connecting protrusion (111) defines a second through hole (1113) on a top wall of the connecting protrusion (111) in the first preset direction (f1), and the second through hole (1113) is in communication with the accommodating cavity (1111) and the first through hole (222); and
the connecting member (40) passes through the first through hole (222) and the second through hole (1113) in sequence from up to down in the first preset direction (f1) and is connected to the connecting base (30).

5. The portable energy storage apparatus (100) of claim 4, wherein a direction perpendicular to both the first preset direction (f1) and an opening direction (f2) of the opening (1112) is defined as a second preset direction (f3), and the opening direction (f2) is defined as a direction from the connecting protrusion (111) towards the energy storage module (20); and
the connecting protrusion (111) has a first sidewall (111a) and a second sidewall (111b) that are opposite to each other in the second preset direction (f3), the connecting protrusion (111) is provided with a limiting rib (112) protruding from the first sidewall (111a), the second sidewall (111b), or the first sidewall (111a) and the second sidewall (112b), the limiting rib (112) is located in the accommodating cavity (1111), and the limiting rib (112) abuts against the connecting base (30).

6. The portable energy storage apparatus (100) of claim 5, wherein a gap is defined between the connecting base (30) and the limiting rib (112) in the second preset direction (f3), and/or an adhesive layer bonded to both the connecting base (30) and the limiting rib (112) is provided in the gap between the connecting base (30) and the limiting rib (112) in the second preset direction (f3).

7. The portable energy storage apparatus (100) of claim 4, wherein the connecting protrusion (111) is provided with a first support rib (113) protruding from a bottom wall of the connecting protrusion (111) in the first preset direction (f1), the first support rib (113) is located in the accommodating cavity (1111), and the first support rib (113) abuts against the connecting base (30).

8. The portable energy storage apparatus (100) of claim 4, wherein the connecting protrusion (111) is provided with a boss (114) extending in the first preset direction (f1) and protruding from the top wall of the connecting protrusion (111) in the first preset direction (f1), the boss (114) is located outside the accommodating cavity (1111), the boss (114) is spaced apart from the inner sidewall surface of the bottom housing (11), and the second through holes (1113) extends through the boss (114) in the first preset direction (f1); and
the boss (114) is provided with a plurality of first reinforcing ribs (115a) arranged at intervals in a circumferential direction of the boss (114), and each of the plurality of first reinforcing ribs (115a) is connected to both an outer peripheral surface of the boss (114) and the top wall of the connecting protrusion (111) in the first preset direction (f1).

9. The portable energy storage apparatus (100) of claim 4, wherein the connecting protrusion (111) is provided with at least one second reinforcing rib (115b) on the top wall of the connecting protrusion (111) in the first preset direction (f1), the at least one second reinforcing rib (115b) is located outside the accommodating cavity (1111), and the at least one second reinforcing rib (115b) is connected to the inner sidewall surface of the bottom housing (11).

10. The portable energy storage apparatus (100) of claim 1, wherein the connecting protrusion (111) is provided with a second support rib (117) on the bottom wall of the connecting protrusion (111) in the first preset direction (f1), the second support rib (117) is located outside the accommodating cavity (1111), the second support rib (117) is connected to the inner sidewall surface of the bottom housing (11), and the second support rib (117) extends in the first preset direction (f1) to be connected to an inner bottom surface of the bottom housing (11).

11. The portable energy storage apparatus (100) of claim 10, wherein a direction perpendicular to both the first preset direction (f1) and an opening direction (f2) of the opening (1112) is defined as a second preset direction (f3), and the opening direction (f2) is defined as a direction from the connecting protrusion (111) towards the energy storage module (20); and
the second support rib (117) comprises at least two support sub-ribs (117a) arranged at intervals in the second preset direction (f3), and a plurality of connecting ribs (118) arranged at intervals in the first preset direction (f1) are connected between adjacent two of the at least two support sub-ribs (117a).

12. The portable energy storage apparatus (100) of any one of claims 1 to 11, wherein the bottom housing (11) has a first abutting surface (11a) at one end of the bottom housing (11) closer to the top housing (12), and the first abutting surface (11a) abuts against the top housing (12); the top housing (12) has a second abutting surface (12a) at one end of the top housing (12) closer to the bottom housing (11), and the second abutting surface (12a) abuts against the first abutting surface (11a); and a positioning protrusion (119) is provided on one of the first abutting surface (11a) and the second abutting surface (12a), a positioning groove (121) is defined in the other of the first abutting surface (11a) and the second abutting surface (12a), and the positioning protrusion (119) is embedded in the positioning groove (121).

13. The portable energy storage apparatus (100) of claim 12, wherein when the positioning protrusion (119) is provided on the first abutting surface (11a) and the positioning groove (121) is defined in the second abutting surface (12a), the positioning groove (121) extends through an inner sidewall surface of the top housing (12), the top housing (12) is provided with a plurality of reinforcing ribs (122) on the inner sidewall surface of the top housing (12), the plurality of reinforcing ribs (122) are arranged at intervals in a circumferential direction of the top housing (12), and each of the plurality of reinforcing ribs (122) extends in the first preset direction (f1) to abut against the positioning protrusion (119).

14. The portable energy storage apparatus (100) of claim 13, wherein the portable energy storage apparatus (100) further comprises a circuit board assembly (50), the circuit board assembly (50) is disposed inside the bottom housing (11), the circuit board assembly (50) is located at one side of the energy storage module (20), and each of a part of the plurality of reinforcing ribs (122) disposed closer to the circuit board assembly (50) defines an avoidance notch (1221) for avoiding the circuit board assembly (50).

15. An energy storage system (1000), wherein the energy storage system (1000) has the portable energy storage apparatus (100) of any one of claims 1 to 14.
